# EUROPÄISCHE PATENTSCHRIFT

(11) **EP 1 979 754 B1**
(45) Veröffentlichungstag und Bekanntmachung des Hinweises auf die Patenterteilung: **18.04.2018**
(21) Anmeldenummer: 06705906.3
(22) Anmeldetag: 01.02.2006
(51) Int. Cl.: G01R 19/165, G01R 15/22, H04B 10/00, H03K 7/02, H03K 19/0175

(54) **ANORDNUNG UND VERFAHREN ZUM UMWANDELN EINES DIGITALEN SIGNALS MIT EINEM HOHEN SPANNUNGSHUB IN EIN DIGITALES SIGNAL MIT EINEM DEMGEGENÜBER KLEINEREN SPANNUNGSHUB**
ARRANGEMENT AND METHOD FOR CONVERTING A DIGITAL SIGNAL WITH A LARGE VOLTAGE SWING INTO A DIGITAL SIGNAL WITH A VOLTAGE SWING WHICH IS SMALLER THAN THE LATTER
DISPOSITIF ET PROCÉDÉ DE CONVERSION D'UN SIGNAL NUMÉRIQUE À GRANDE PLAGE DE TENSION EN UN SIGNAL NUMÉRIQUE À PLAGE DE TENSION COMPARATIVEMENT PLUS PETITE

(43) Veröffentlichungstag der Anmeldung: 15.10.2008
(73) Patentinhaber: Siemens Aktiengesellschaft, 80333 München (DE)
(72) Erfinder: GRÖSSLER, Stefan, 12459 Berlin (DE); KAPP, Harald, 10709 Berlin (DE); ULBRICH, Frank, 13439 Berlin (DE)
(86) Internationale Anmeldenummer: PCT/DE2006/000178
(87) Internationale Veröffentlichungsnummer: WO 2007/087766

(56) Entgegenhaltungen:
- CH-A5- 676 393
- DE-A1- 4 340 950
- DE-U1- 29 717 369
- US-B1- 6 885 184
- EVEREST R: "Two wire A/D converter" NEW ELECTRONICS, INTERNATIONAL THOMSON PUBLISHING, LONDON, GB, Bd. 20, Nr. 13, 23. Juni 1987 (1987-06-23), Seite 15, XP007901134 ISSN: 0047-9624

## Beschreibung

Die Erfindung bezieht sich auf eine Anordnung zum Umwandeln eines ersten digitalen Signals - nachfolgend kurz digitales Hochspannungssignal genannt - mit einem ersten Spannungshub in ein zweites digitales Signal - nachfolgend kurz digitales Niederspannungssignal genannt - mit einem gegenüber dem ersten Spannungshub kleineren zweiten Spannungshub. Die Begriffe Hochspannungssignal und Niederspannungssignal drücken in diesem Zusammenhang lediglich das relative Spannungsverhältnis zwischen den beiden Signalen aus und beziehen sich nicht auf absolute Spannungsbereiche; der absolute Spannungsbereich spielt für die Erfindung keine Rolle: So können die beiden Signale beispielsweise jeweils in einem Spannungsbereich zwischen 0 und 5 V oder auch in einem Spannungsbereich von vielen hundert Volt liegen. Zum Beispiel kann das Hochspannungssignal einen Spannungshub zwischen 0 und 10-300 V aufweisen und das Niederspannungssignal in einem Bereich zwischen 0 und 5 V liegen. Unter dem Begriff Spannungshub ist dabei die Differenz zwischen dem maximalen Spannungswert und dem minimalen Spannungswert des jeweiligen Signals zu verstehen.

Eine Anordnung zum Umwandeln eines digitalen Hochspannungssignals in ein digitales Niederspannungssignal kann beispielsweise durch einen ohmschen Spannungsteiler gebildet sein, der mindestens zwei in Reihe geschaltete ohmsche Widerstände aufweist. Wird außen an die Reihenschaltung ein digitales Hochspannungssignal angelegt, so kann an jedem der in Reihe geschalteten ohmschen Widerstände ein digitales Spannungssignal abgegriffen werden, das einen geringeren Spannungshub als das eingangsseitig anliegende digitale Hochspannungssignal aufweist. Eine solche Anordnung ist jedoch mit dem Nachteil behaftet, dass relativ hohe elektrische Verluste auftreten, da an der Reihenschaltung der ohmschen Einzelwiderstände stets das digitale Hochspannungssignal anliegt.

Eine Vorrichtung zum Umwandeln eines Spannungswertes mit gleichzeitiger Unterdrückung des Rauschens ist beispielsweise aus der DE 43 40 950 A1 bekannt.

Der Erfindung liegt die Aufgabe zugrunde, eine Anordnung zum Umwandeln eines digitalen Hochspannungssignals in ein digitales Niederspannungssignal anzugeben, bei dem möglichst geringe elektrische Verluste auftreten. Außerdem soll in relativ einfacher Weise gleichzeitig eine galvanische Trennung zwischen dem digitalen Hochspannungssignal und dem digitalen Niederspannungssignal erreicht werden.

Diese Aufgabe wird erfindungsgemäß durch eine Anordnung mit einer Schwellwertdetektionseinrichtung erreicht, die ein eingangsseitig anliegendes Eingangssignal, das dem digitalen Hochspannungssignal entspricht, mit einem Schwellenwert vergleicht und die - wenn das Eingangssignal den Schwellenwert überschreitet - eine Pulsfolge bestehend aus Einschalt- und Ausschaltimpulsen erzeugt. Die Einschaltimpulse weisen eine vorgegebene Einschaltdauer und eine vorgegebene Einschaltamplitude und die Ausschaltimpulse eine vorgegebene Ausschaltdauer und eine vorgegebene Ausschaltamplitude auf. Die Ausschaltamplitude ist dabei kleiner als die Einschaltamplitude. Außerdem weist die erfindungsgemäße Anordnung eine galvanische Trenneinrichtung auf, die mit dem Ausgang der Schwellwertdetektionseinrichtung verbunden ist und die Pulsfolge der Schwellwertdetektionseinrichtung unter Potentialtrennung an einen Signalausgang der galvanischen Trenneinrichtung weiterleitet. Darüber hinaus ist erfindungsgemäß eine mit der galvanischen Trenneinrichtung verbundene Signalrückgewinnungseinrichtung vorhanden, die mit der am Signalausgang der galvanischen Trenneinrichtung anliegenden Pulsfolge das digitale Niederspannungssignal erzeugt.

Ein wesentlicher Vorteil der erfindungsgemäßen Anordnung ist darin zu sehen, dass bei dieser nur relativ geringe elektrische Verluste auftreten. Bei der erfindungsgemäßen Anordnung wird nämlich eine Pulsfolge erzeugt, wenn das digitale Hochspannungssignal eine binäre logische "1" aufweist; dies ermöglicht es, die galvanische Trenneinrichtung sowie die Signalrückgewinnungseinrichtung während einer logischen Eins nicht permanent, sondern nur dann elektrisch aktiv zu betreiben, wenn die Pulsfolge Einschaltimpulse erzeugt. Während der Ausschaltimpulse kann die galvanische Trenneinrichtung inaktiv geschaltet werden, wodurch der Energieverbrauch der Gesamtanordnung reduziert wird. Der Energieverbrauch der Anordnung wird dabei durch das Verhältnis der Einschaltdauer der Einschaltimpulse relativ zur Ausschaltdauer der Ausschaltimpulse bestimmt.

Ein weiterer wesentlicher Vorteil der erfindungsgemäßen Anordnung ist darin zu sehen, dass durch die galvanische Trenneinrichtung eine galvanische Entkopplung zwischen dem digitalen Hochspannungssignal und dem digitalen Niederspannungssignal erreicht wird; elektrische Verluste durch die galvanische Trenneinrichtung sind dabei gering, da sich diese - wie erläutert - elektrisch zwischen der Schwellwertdetektionseinrichtung, mit der die Pulsfolge mit den Einschalt- und den Ausschaltimpulsen erzeugt wird, und der Signalrückgewinnungseinrichtung befindet und somit nur während des Vorliegens von Einschaltimpulsen betrieben wird.

Zur Energieversorgung der Schwellwertdetektionseinrichtung wird vorzugsweise das digitale Hochspannungssignal herangezogen; hierzu wird mit der Schwellwertdetektionseinrichtung bevorzugt ein Spannungsregler verbunden, an den eingangsseitig das digitale Hochspannungssignal angelegt wird und der mit diesem eine Versorgungsspannung für die Schwellwertdetektionseinrichtung bildet.

Besonders bevorzugt handelt es sich bei dem Spannungsregler um einen Tiefsetzsteller, der gewährleistet, dass die Versorgungsspannung für die Schwellwertdetektionseinrichtung einen kleineren Spannungshub aufweist als das digitale Hochspannungssignal am Eingang des Spannungsreglers. Die Versorgungsspannung für die Schwellwertdetektionseinrichtung wird mit dem Spannungsregler vorzugsweise so eingestellt, dass diese eine insgesamt möglichst minimale elektrische Verlustleistung aufweist.

Um zu erreichen, dass die Schwellwertdetektionseinrichtung, die galvanische Trenneinrichtung und die nachgeschaltete Signalrückgewinnungseinrichtung insgesamt möglichst wenig Verlustleistung erzeugen, wird es als vorteilhaft angesehen, wenn die Ausschaltamplitude der Ausschaltimpulse möglichst gering ist und idealerweise 0 V beträgt.

Die Signalrückgewinnungseinrichtung ist besonders bevorzugt derart ausgestaltet, dass sie mit der am Signalausgang der galvanischen Trenneinrichtung anliegenden Pulsfolge das digitale Niederspannungssignal derart erzeugt, dass dieses einen Signalverlauf aufweist, der zu dem Signalverlauf des digitalen Hochspannungssignals - von einem etwaigen zeitlichen Versatz abgesehen - proportional ist. Besonders bevorzugt entspricht die im digitalen Niederspannungssignal enthaltene binäre Information derjenigen des digitalen Hochspannungssignals.

Die Signalrückgewinnungseinrichtung kann beispielsweise durch ein integrierendes Element, beispielsweise durch eine entsprechende Operationsverstärkerschaltung, gebildet sein oder eine solches umfassen. Alternativ oder zusätzlich kann die Signalrückgewinnungseinrichtung auch eine Mikroprozessorschaltung aufweisen, mit der aus der Pulsfolge der Schwellwertdetektionseinrichtung das vom Signalverlauf her dem digitalen Hochspannungssignal entsprechende Niederspannungssignal gebildet wird.

Die Erfindung bezieht sich außerdem auf ein Verfahren zum Umwandeln eines ersten digitalen Signals (Hochspannungssignal) in ein zweites digitales Signal (Niederspannungssignal) mit niedrigerem Spannungshub.

Diesbezüglich liegt der Erfindung die Aufgabe zugrunde, ein Verfahren anzugeben, bei dem eine möglichst geringe Verlustleistung beim Umwandeln erzeugt wird und bei dem trotzdem eine galvanische Trennung zwischen dem eingangsseitigen Hochspannungssignal und dem ausgangsseitigen Niederspannungssignal erreicht wird.

Diese Aufgabe wird erfindungsgemäß dadurch gelöst, dass das erste digitale Signal mit einem Schwellenwert verglichen wird, dass - wenn das erste digitale Signal den Schwellenwert überschreitet - eine Pulsfolge bestehend aus Einschalt- und Ausschaltimpulsen erzeugt wird, wobei die Einschaltimpulse eine vorgegebene Einschaltdauer und eine vorgegebene Einschaltamplitude und die Ausschaltimpulse eine vorgegebene Ausschaltdauer und eine vorgegebene Ausschaltamplitude aufweisen und wobei die Ausschaltamplitude kleiner als die Einschaltamplitude eingestellt wird, dass die Pulsfolge einer Potentialtrennung unter Bildung einer potentialgetrennten Pulsfolge unterzogen wird und dass mit der potentialgetrennten Pulsfolge das zweite digitale Signal erzeugt wird.

Vorteilhafte Ausgestaltungen des erfindungsgemäßen Verfahrens sind in Unteransprüchen angegeben.

Bezüglich der Vorteile des erfindungsgemäßen Verfahrens sowie bezüglich der Vorteile vorteilhafter Ausgestaltungen des erfindungsgemäßen Verfahrens sei auf die obigen Ausführungen im Zusammenhang mit der erfindungsgemäßen Anordnung verwiesen.

Die Erfindung wird nachfolgend anhand von Ausführungsbeispielen näher erläutert. Dabei zeigen beispielhaft
Figur 1 ein Blockschaltbild eines Ausführungsbeispiels einer Anordnung zum Umwandeln eines digitalen Hochspannungssignals in ein digitales Niederspannungssignal,
Figur 2 den zeitlichen Verlauf der in der Anordnung gemäß der Figur 1 auftretenden Signale,
Figur 3 ein Ausführungsbeispiel für eine elektrische Schaltung, die von der Funktion her dem Blockschaltbild gemäß Figur 1 entspricht,
Figur 4 ein Ausführungsbeispiel für eine Signalrückgewinnungseinrichtung für die Anordnung gemäß den Figuren 1 und 2 und
Figur 5 ein weiteres Ausführungsbeispiel für eine Signalrückgewinnungseinrichtung für die Anordnung gemäß den Figuren 1 und 2.

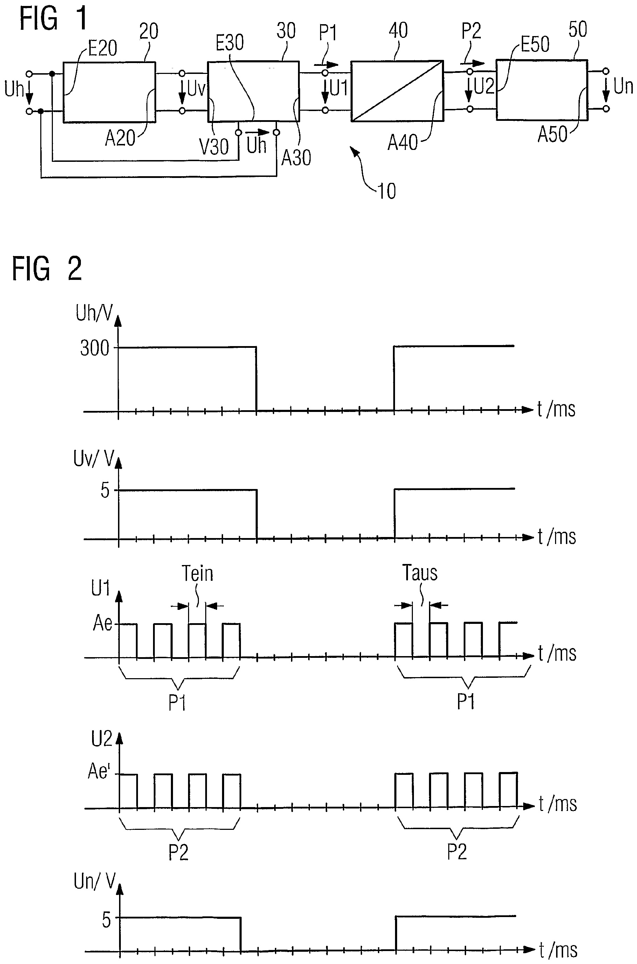

In der Figur 1 ist eine Anordnung 10 zum Umwandeln eines ersten digitalen binären Signals - nachfolgend digitales Hochspannungssignal Uh genannt - in ein zweites digitales binäres Signal - nachfolgend kurz Niederspannungssignal Un genannt - dargestellt. Das digitale Hochspannungssignal Uh weist beispielsweise im Falle einer logischen bzw. binären "Eins" eine Spannung Uh zwischen 10 V und 300 V und im Falle einer logischen bzw. binären "Null" eine Spannung von Null Volt auf. Nachfolgend wird beispielhaft davon ausgegangen, dass die Spannung Uh für eine logische "Eins" 300 Volt beträgt.

Die Anordnung 10 umfasst eingangsseitig einen Spannungsregler 20, der an seinem Signaleingang E20 mit dem digitalen Hochspannungssignal Uh beaufschlagt ist. Der Spannungsregler 20 erzeugt mit dem eingangsseitig anliegenden digitalen Hochspannungssignal Uh eine Versorgungsspannung Uv und gibt diese an einem Ausgang A20 ab. Mit dem Ausgang A20 des Spannungsreglers 20 ist ein Spannungsversorgungsanschluss V30 einer Schwellwertdetektionseinrichtung 30 verbunden. Durch die von dem Spannungsregler 20 erzeugte Versorgungsspannung Uv wird die Schwellwertdetektionseinrichtung 30 mit elektrischer Energie zu deren Betrieb versorgt. Die Schwellwertdetektionseinrichtung 30 weist darüber hinaus einen Signaleingang E30 auf, der mit dem digitalen Hochspannungssignal Uh beaufschlagt ist.

Einem Ausgang A30 der Schwellwertdetektionseinrichtung 30 ist eine galvanische Trenneinrichtung 40 nachgeordnet, deren Signalausgang A40 mit einer Signalrückgewinnungseinrichtung 50 verbunden ist. Die Signalrückgewinnungseinrichtung 50 erzeugt ausgangsseitig das digitale Niederspannungssignal Un.

Die Anordnung gemäß der Figur 1 lässt sich wie folgt betreiben:

Liegt am Eingang E20 des Spannungsreglers 20 eine Eingangsspannung an, die eine für den Betrieb des Spannungsreglers 20 vorgegebene Minimalspannung (z. B. mindestens 5 V) überschreitet, so wird der Spannungsregler 20 in Betrieb genommen. Während des Betriebs des Spannungsreglers 20 erzeugt dieser an seinem Ausgang A20 die Versorgungsspannung Uv, die aufgrund der Reglereigenschaften des Spannungsreglers 20 unabhängig von der konkreten Höhe des Hochspannungssignals Uh weitgehend konstant ist. Die Ausgangsspannung Uv kann beispielsweise 5 V betragen, und zwar unabhängig davon, ob das Hochspannungssignals Uh im Falle einer logischen Eins eine Spannung von 10 Volt oder von 300 Volt erzeugt.

Sobald an dem Spannungsversorgungsanschluss V30 der Schwellwertdetektionseinrichtung 30 die Versorgungsspannung Uv vom Spannungsregler 20 bereitgestellt wird, wird auch die Schwellwertdetektionseinrichtung 30 in Betrieb genommen. Dies führt dazu, dass die Schwellwertdetektionseinrichtung 30 das an ihrem Signaleingang E30 anliegende digitale Hochspannungssignal Uh mit einem in der Schwellwertdetektionseinrichtung 30 fest vorgegebenen bzw. fest eingestellten Schwellenwert (z. B. mindestens 5 V) vergleicht.

Überschreitet das digitale Hochspannungssignal Uh diesen Schwellenwert, so erzeugt die Schwellwertdetektionseinrichtung 30 eine Pulsfolge P1 bestehend aus einer Vielzahl von Einschalt- und Ausschaltimpulsen, die sich abwechseln; dies ist in der Figur 2 dargestellt. Die Einschaltimpulse weisen dabei eine vorgegebene Einschaltdauer und eine vorgegebene Einschaltamplitude auf; entsprechendes gilt für die Ausschaltimpulse, die ebenfalls eine vorgegebene Ausschaltdauer und eine vorgegebene Ausschaltamplitude aufweisen. Beispielsweise erzeugt die Schwellwertdetektionseinrichtung 30 eine Pulsfolge mit Einschaltimpulsen, die eine Einschaltamplitude Ae von 5 V und eine Einschaltdauer Tein von beispielsweise einer Millisekunde aufweisen. Die Ausschaltimpulse weisen beispielsweise eine Ausschaltamplitude Aa = 0 V und eine Ausschaltdauer Taus = 1 ms auf.

Unterschreitet hingegen das digitale Hochspannungssignal Uh den der Schwellwertdetektionseinrichtung 30 vorgegebenen Schwellenwert, so erzeugt die Schwellwertdetektionseinrichtung 30 ausgangsseitig vorzugsweise eine möglichst kleine Gleichspannung, beispielsweise eine Gleichspannung von 0 V. In diesem Fall wird also keine Pulsfolge, sondern lediglich ein einziges Spannungspotential (z. B von 0 V) an die galvanische Trenneinrichtung 40 angelegt.

Die galvanische Trenneinrichtung 40, bei der es sich beispielsweise um einen Optokoppler handelt, erzeugt bei Vorliegen der beschriebenen Pulsfolge P1 an ihrem Signalausgang A40 ebenfalls eine Pulsfolge, die von der eingangsseitig anliegenden und von der Schwellwertdetektionseinrichtung 30 gebildeten Pulsfolge P1 galvanisch getrennt ist. Diese Pulsfolge weist die Amplitude Ae' auf ist in der Figur 2 mit dem Bezugszeichen P2 gekennzeichnet.

Die von der galvanischen Trenneinrichtung 40 gebildete Pulsfolge P2 gelangt zu der Signalrückgewinnungseinrichtung 50, die aus der eingangsseitig anliegenden Pulsfolge P2 das digitale Niederspannungssignal Un bildet. Hierzu erzeugt die Signalrückgewinnungseinrichtung 50 ausgangsseitig ein Signal mit einer logischen binären "1" in Form einer Ausgangsspannung von beispielsweise 5 V, sofern eingangsseitig eine Pulsfolge P2 mit sich abwechselnden Einschalt- und Ausschaltimpulsen anliegt; liegt hingegen keine Pulsfolge an, weil die galvanische Trenneinrichtung 40 keine entsprechende Pulsfolge P2 liefert, so erzeugt die Signalrückgewinnungseinrichtung 50 an ihrem Ausgang A50 eine logische binäre "0" vorzugsweise mit einem Spannungspotential von 0 V.

In der Figur 2 ist der zeitliche Verlauf des digitalen Hochspannungssignals Uh, der Pulsfolgen P1 und P2 am Ausgang der Schwellwertdetektionseinrichtung 30 bzw. der galvanischen Trenneinrichtung 40 sowie des sich daraus ergebenden digitalen Niederspannungssignals Un beispielhaft dargestellt.

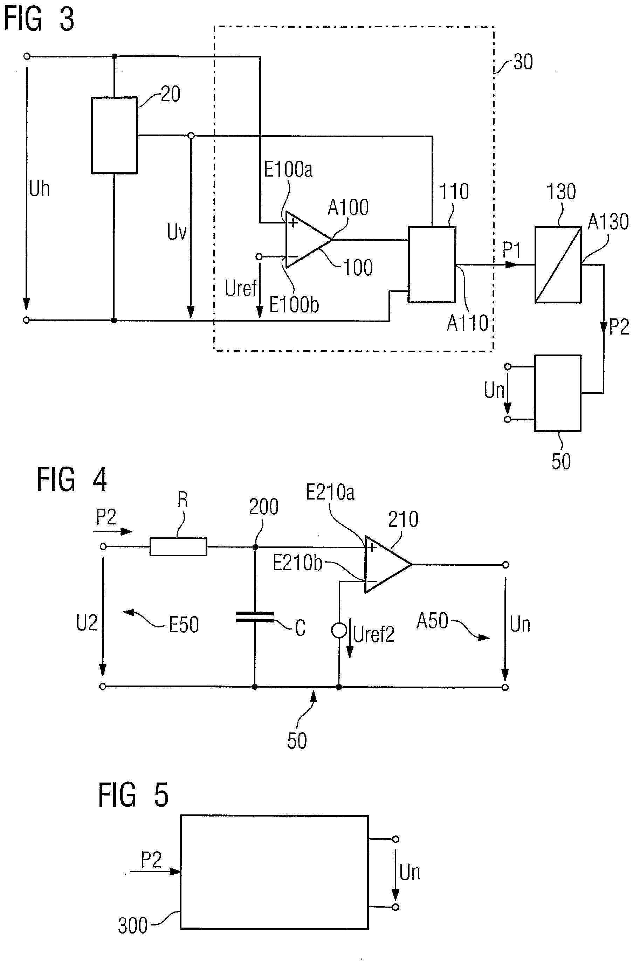

In der Figur 3 ist ein Ausführungsbeispiel für eine konkrete schaltungstechnische Umsetzung des Blockschaltbilds gemäß der Figur 1 gezeigt. Man erkennt den Spannungsregler 20, der eingangsseitig mit dem digitalen Hochspannungssignal Uh beaufschlagt ist.

Außerdem erkennt man die Schwellwertdetektionseinrichtung 30, die beispielsweise einen Operationsverstärker 100 umfassen kann. Einer der beiden Signaleingänge E100a des Operationsverstärkers 100 ist mit dem digitalen Hochspannungssignal Uh beaufschlagt. Der andere Signaleingang E100b des Operationsverstärkers 100 ist an eine Referenzspannung Uref angeschlossen, die den Schwellenwert der Schwellwertdetektionseinrichtung 30 - wie beschrieben - bestimmt.

Mit dem Ausgang A100 des Operationsverstärkers 100 ist ein Pulsfolgegenerator 110 verbunden, der bei Anliegen eines entsprechenden Ansteuersignals durch den Operationsverstärker 100 eine Pulsfolge bestehend aus aufeinander folgenden Einschalt- und Ausschaltimpulsen erzeugt. Die von dem Pulsfolgegenerator 110 gebildete Pulsfolge entspricht der in der Figur 2 dargestellten Pulsfolge P1.

Der Ausgang A110 des Pulsfolgegenerators 110 steht mit einem Optokoppler 130 in Verbindung, der die galvanische Trenneinrichtung 40 gemäß Figur 1 bildet. Am Ausgang A130 des Optokopplers ist die Signalrückgewinnungseinrichtung 50 angeschlossen, die aus der eingangsseitig anliegenden Pulsfolge P2 des Optokopplers 130 das digitale Niederspannungssignal Un erzeugt.

In der Figur 4 ist ein Ausführungsbeispiel für die Signalrückgewinnungseinrichtung 50 gemäß den Figuren 1 und 3 gezeigt. Man erkennt einen Widerstand R und einen Kondensator C, an deren Verbindungsstelle 200 ein Eingang E210a eines Operationsverstärkers 210 angeschlossen ist. Ein anderer Eingang E210b des Operationsverstärkers 210 ist mit einer Referenzspannung Uref2 (z. B. Uref2 = 2,5 V) beaufschlagt.

Liegt an der Signalrückgewinnungseinrichtung 50 eine Pulsfolge P2 an, so erzeugt der Operationsverstärker 210 ausgangsseitig ein Signal mit einer logischen "1". Liegt hingegen am Eingang E50 der Signalrückgewinnungseinrichtung 50 keine Pulsfolge, sondern lediglich ein Potential von 0 V an, so erzeugt der Operationsverstärker 210 am Ausgang A50 eine Ausgangsspannung Un von 0 V. Mit der durch den Widerstand R, den Kondensator C sowie den Operationsverstärker 210 gebildeten Schaltung lässt sich somit aus der eingangsseitig anliegenden Pulsfolge P2 ein digitales Ausgangssignal Un erzeugen, das - von einer Phasenverschiebung bzw. einem zeitlichen Versatz abgesehen - proportional zum digitalen Hochspannungssignal Uh am Eingang der Schwellwertdetektionseinrichtung 30 verläuft.

In der Figur 5 ist ein weiteres Ausführungsbeispiel für eine technische Realisierung der Signalrückgewinnungseinrichtung 50 gemäß den Figuren 1 und 3 gezeigt. Man erkennt eine Mikroprozessoreinrichtung 300, die eine eingangsseitig anliegende Pulsfolge P2 in ein rechteckförmiges Signal umwandelt, wobei das rechteckförmige Signal stets eine logische "1" aufweist, wenn eingangsseitig sich abwechselnde Einschalt- und Ausschaltimpulse anliegen, und ansonsten eine logische "0" aufweist.

## Patentansprüche

1. Anordnung (10) zum Umwandeln eines ersten digitalen Signals (Uh) mit einem ersten Spannungshub in ein zweites digitales Signal (Un) mit einem gegenüber dem ersten Spannungshub kleineren Spannungshub,
die Anordnung dadurch definiert, dass eine Schwellwertdetektionseinrichtung (30), die ein eingangsseitig anliegendes Eingangssignal, das dem ersten digitalen Signal entspricht, mit einem Schwellenwert (Uref) vergleicht und die - wenn das Eingangssignal den Schwellenwert überschreitet - eine Pulsfolge (P1) bestehend aus Einschalt- und Ausschaltimpulsen erzeugt, wobei die Einschaltimpulse eine vorgegebene Einschaltdauer (Tein) und eine vorgegebene Einschaltamplitude (Ae) und die Ausschaltimpulse eine vorgegebene Ausschaltdauer (Taus) und eine vorgegebene Ausschaltamplitude aufweisen und wobei die Ausschaltamplitude kleiner als die Einschaltamplitude ist,
- eine galvanische Trenneinrichtung (40), die mit dem Ausgang (A30) der Schwellwertdetektionseinrichtung (30) verbunden ist und die Pulsfolge (P1) der Schwellwertdetektionseinrichtung unter Potentialtrennung an einen Signalausgang (A40) der galvanischen Trenneinrichtung weiterleitet, und
- eine mit der galvanischen Trenneinrichtung verbundene Signalrückgewinnungseinrichtung (50), die mit der am Signalausgang (A50) der galvanischen Trenneinrichtung anliegenden Pulsfolge (P2) das zweite digitale Signal erzeugt.

2. Anordnung nach Anspruch 1,
**dadurch gekennzeichnet, dass** mit der Schwellwertdetektionseinrichtung ein Spannungsregler (20) verbunden ist, an dem eingangsseitig das erste digitale Signal anliegt und der mit diesem eine Versorgungsspannung (Uv) für die Schwellwertdetektionseinrichtung bildet.

3. Anordnung nach Anspruch 2,
**dadurch gekennzeichnet, dass** der Spannungsregler ein Tiefsetzsteller ist, der gewährleistet, dass die Versorgungsspannung für die Schwellwertdetektionseinrichtung eine kleinere Spannung aufweist als das erste digitale Signal am Eingang des Spannungsreglers.

4. Anordnung nach einem der vorangehenden Ansprüche,
**dadurch gekennzeichnet, dass** die Ausschaltamplitude Null Volt beträgt.

5. Anordnung nach einem der vorangehenden Ansprüche,
**dadurch gekennzeichnet, dass** die Signalrückgewinnungseinrichtung mit der am Signalausgang der galvanischen Trenneinrichtung anliegenden Pulsfolge das zweite digitale Signal derart erzeugt, dass dieses einen Signalverlauf aufweist, der zu dem Signalverlauf des ersten digitalen Signals - von einem zeitlichen Versatz abgesehen - proportional ist.

6. Anordnung nach einem der vorangehenden Ansprüche,
**dadurch gekennzeichnet, dass** die Signalrückgewinnungseinrichtung derart ausgestaltet ist, dass die im zweiten digitalen Signal enthaltene binäre Information derjenigen des ersten digitalen Signals entspricht.

7. Anordnung nach einem der vorangehenden Ansprüche,
**dadurch gekennzeichnet, dass** die Signalrückgewinnungseinrichtung ein integrierendes Element (R, C, 210) umfasst.

8. Anordnung nach einem der vorangehenden Ansprüche 1-6,
**dadurch gekennzeichnet, dass** die Signalrückgewinnungseinrichtung eine Mikroprozessorschaltung (300) umfasst.

9. Verfahren zum Umwandeln eines ersten digitalen Signals (Uh) mit einem ersten Spannungshub in ein zweites digitales Signal (Un) mit einem gegenüber dem ersten Spannungshub kleineren Spannungshub,
das Verfahren dadurch definiert, dass
- das erste digitale Signal mit einem Schwellenwert (Uref) verglichen wird,
- dass - wenn das erste digitale Signal den Schwellenwert überschreitet - eine Pulsfolge (P1) bestehend aus Einschalt- und Ausschaltimpulsen erzeugt wird, wobei die Einschaltimpulse eine vorgegebene Einschaltdauer (Tein) und eine vorgegebene Einschaltamplitude (Ae) und die Ausschaltimpulse eine vorgegebene Ausschaltdauer (Taus) und eine vorgegebene Ausschaltamplitude aufweisen und wobei die Ausschaltamplitude kleiner als die Einschaltamplitude eingestellt wird,
- dass die Pulsfolge (P1) einer Potentialtrennung unter Bildung einer potentialgetrennten Pulsfolge (P2) unterzogen wird und
- dass mit der potentialgetrennten Pulsfolge (P2) das zweite digitale Signal erzeugt wird.

10. Verfahren nach Anspruch 9,
**dadurch gekennzeichnet, dass** mit der potentialgetrennten Pulsfolge (P2) das zweite digitale Signal derart erzeugt, dass dieses einen Signalverlauf aufweist, der zu dem Signalverlauf des ersten digitalen Signals - von einem zeitlichen Versatz abgesehen - proportional ist.

## Claims

1. Arrangement (10) for converting a first digital signal (Uh) with a first voltage swing into a second digital signal (Un) with a voltage swing which is smaller than the first voltage swing,
the arrangement defined by
a threshold value detection device (30) which compares an input signal, which is applied to the input and corresponds to the first digital signal with a threshold value (Uref) and which - if the input signal exceeds the threshold value - generates a pulse sequence (P1) comprising switch-on and switch-off pulses, the switch-on pulses having a predefined switch-on duration (Tein) and a predefined switch-on amplitude (Ae) and the switch-off pulses having a predefined switch-off duration (Taus) and a predefined switch-off amplitude, and the switch-off amplitude being smaller than the switch-on amplitude,
- a DC isolation device (40) which is connected to the output (A30) of the threshold value detection device (30) and forwards the pulse sequence (P1) from the threshold value detection device, with electrical isolation, to a signal output (A40) of the DC isolation device, and
- a signal recovery device (50) which is connected to the DC isolation device and generates the second digital signal using the pulse sequence (P2) which is applied to the signal output (A50) of the DC isolation device.

2. Arrangement according to Claim 1,
**characterized in that**
a voltage regulator (20) is connected to the threshold value detection device, the first digital signal being applied to the input of said voltage regulator and said voltage regulator using this first digital signal to form a supply voltage (Uv) for the threshold value detection device.

3. Arrangement according to Claim 2,
**characterized in that**
the voltage regulator is a step-down controller which ensures that the supply voltage for the threshold value detection device has a smaller voltage than the first digital signal at the input of the voltage regulator.

4. Arrangement according to one of the preceding claims,
**characterized in that**
the switch-off amplitude is zero volts.

5. Arrangement according to one of the preceding claims,
**characterized in that**
the signal recovery device uses the pulse sequence applied to the signal output of the DC isolation device to generate the second digital signal in such a manner that the latter has a signal profile which is proportional to the signal profile of the first digital signal, apart from a temporal offset.

6. Arrangement according to one of the preceding claims,
**characterized in that**
the signal recovery device is configured in such a manner that the binary information contained in the second digital signal corresponds to that in the first digital signal.

7. Arrangement according to one of the preceding claims,
**characterized in that**
the signal recovery device comprises an integrating element (R, C, 210).

8. Arrangement according to one of the preceding Claims 1-6,
**characterized in that**
the signal recovery device comprises a microprocessor circuit (300) .

9. Method for converting a first digital signal (Uh) with a first voltage swing into a second digital signal (Un) with a voltage swing which is smaller than the first voltage swing, the method defined in that
- the first digital signal is compared with a threshold value (Uref),
- in that, if the first digital signal exceeds the threshold value, a pulse sequence (P1) comprising switch-on and switch-off pulses is generated, the switch-on pulses having a predefined switch-on duration (Tein) and a predefined switch-on amplitude (Ae) and the switch-off pulses having a predefined switch-off duration (Taus) and a predefined switch-off amplitude, and the switch-off amplitude being set to be smaller than the switch-on amplitude,
- in that the pulse sequence (P1) is subjected to electrical isolation so as to form an electrically isolated pulse sequence (P2), and
- in that the electrically isolated pulse sequence (P2) is used to generate the second digital signal.

10. Method according to Claim 9,
**characterized in that**
the electrically isolated pulse sequence (P2) is used to generate the second digital signal in such a manner that the latter has a signal profile which is proportional to the signal profile of the first digital signal, apart from a temporal offset.

## Revendications

1. Montage (10) de transformation d'un premier signal (Uh) numérique, ayant une première plage de tension en un deuxième signal (Un) numérique, ayant une plage de tension plus petite que la première plage de tension, le montage étant défini en ce qu'un dispositif (30) de détection de valeur de seuil, qui compare un signal d'entrée, qui est appliqué du côté de l'entrée et qui correspond au premier signal numérique, à une valeur (Uref) de seuil, et qui produit - si le signal d'entrée dépasse la valeur de seuil - un train d'impulsions constitué d'impulsions de mise en circuit et de mise hors circuit, les impulsions de mise en circuit ayant une durée (Tein) de mise en circuit donnée à l'avance et une amplitude (Ae) de mise en circuit donnée à l'avance et les impulsions de mise hors circuit, une durée (Taus) de mise hors circuit donnée à l'avance et une amplitude de mise hors circuit donnée à l'avance et l'amplitude de mise hors circuit étant plus petite que l'amplitude de mise en circuit,
- un dispositif (40) de séparation galvanique, qui est relié à la sortie (A30) du dispositif (30) de détection de valeur de seuil et qui achemine le train (P1) d'impulsions du dispositif de détection de valeur de seuil, avec séparation de potentiel, à une sortie (A40) de signal du dispositif de séparation galvanique, et
- un dispositif (50) de récupération du signal, qui est relié au dispositif de séparation galvanique et qui produit le deuxième signal numérique par le train (P2) d'impulsions s'appliquant à la sortie (A50) de signal du dispositif de séparation galvanique.

2. Montage suivant la revendication 1,
**caractérisé en ce que**
au dispositif de détection de valeur de seuil est relié un régleur (20) de tension, auquel s'applique du côté de l'entrée le premier signal numérique et qui forme, avec celui-ci, une tension (Uv) d'alimentation du dispositif de détection de valeur de seuil.

3. Montage suivant la revendication 2,
**caractérisé en ce que**
le régleur de tension est un abaisseur de tension, qui assure que, la tension d'alimentation du dispositif de détection de valeur de seuil a une valeur plus petite que le premier signal numérique à l'entrée du régleur de tension.

4. Montage suivant l'une des revendications précédentes,
**caractérisé en ce que**
l'amplitude de mise hors circuit est égale à zéro volt.

5. Montage suivant l'une des revendications précédentes,
**caractérisé en ce que**
le dispositif de récupération du signal produit, par le train d'impulsions s'appliquant à la sortie de signal du dispositif de séparation galvanique, le deuxième signal numérique, de manière à ce que celui-ci ait une courbe de signal, qui est proportionnelle à la courbe de signal du premier signal numérique - abstraction faite d'un décalage dans le temps.

6. Montage suivant l'une des revendications précédentes,
**caractérisé en ce que**
le dispositif de récupération du signal est conformé, de manière à ce que l'information binaire contenue dans le deuxième signal numérique corresponde à celle du premier signal numérique.

7. Montage suivant l'une des revendications précédentes,
**caractérisé en ce que**
le dispositif de récupération du signal comprend un élément (R, C, 210) d'intégration.

8. Montage suivant l'une des revendications précédentes 1 à 6,
**caractérisé en ce que**
le dispositif de récupération du signal comprend un circuit (300) à microprocesseur.

9. Procédé de transformation d'un premier signal (Uh) numérique, ayant une première plage de tension, en un deuxième signal (Un) numérique ayant une plage de tension plus petite que la première,
le procédé étant défini,
- en ce que l'on compare le premier signal numérique à une valeur (Uref) de seuil,
- en ce que - si le premier signal numérique dépasse la valeur de seuil - on produit un train (P1) d'impulsions, constitué d'impulsions de mise en circuit et d'impulsions de mise hors circuit, les impulsions de mise en circuit ayant une durée (Tein) de mise en circuit donnée à l'avance et une amplitude (Ae) de mise en circuit donnée à l'avance et les impulsions de mise hors circuit ayant une durée (Taus) de mise hors circuit donnée à l'avance et une amplitude de mise hors circuit donnée à l'avance, et dans lequel on règle l'amplitude de mise hors circuit à une valeur plus petite que l'amplitude de mise en circuit,
- en ce que l'on soumet le train (P1) d'impulsions à une séparation de potentiel, en formant un train (P2) d'impulsions séparé en potentiel, et
- en ce que l'on produit le deuxième signal numérique par le train (P2) d'impulsions séparé en potentiel.

10. Procédé suivant la revendication 9,
**caractérisé en ce que**
on produit par le train (P2) d'impulsions séparé en potentiel le deuxième signal numérique, de manière à ce que celui-ci ait une courbe de signal, qui est proportionnelle à la courbe de signal du premier signal numérique - abstraction faite d'un décalage dans le temps.
